# EUROPÄISCHE PATENTANMELDUNG

(11) **EP 2 288 243 A1**
(43) Veröffentlichungstag der Anmeldung: **23.02.2011**
(21) Anmeldenummer: 10006519.2
(22) Anmeldetag: 23.06.2010
(51) Int. Cl.: H05K 3/36, H01R 13/24

(54) **Verfahren zur Herstellung einer elektrischen Verbindung zwischen Leiterplatten**

(30) Priorität: 20.08.2009 DE 102009028744
(71) Anmelder: SEMIKRON Elektronik GmbH & Co. KG, 90431 Nürnberg (DE)
(72) Erfinder: Frenznick, Elke, 96114 Hirschaid (DE)

(57) **Zusammenfassung**

Die Erfindung betrifft ein Verfahren zur Herstellung einer elektrischen Verbindung zwischen einer auf einer ersten Oberfläche (O1) einer ersten Leiterplatte (1) vorgesehenen ersten Kontaktfläche (3) und einer auf einer zweiten Oberfläche (02) einer zweiten Leiterplatte (2) vorgesehenen zweiten Kontaktfläche (10), mit folgenden Schritten:
Vorsehen eines von der ersten Kontaktfläche (3) sich erstreckenden Kanals (5),
Auffüllen des Kanals (5) mit elektrisch leitfähigen, im Wesentlichen kugelförmig ausgebildeten Kontaktelementen (6), so dass die Kontaktelemente (6) teilweise über einen freien Öffnungsrand des Kanals (5) hervorstehen,
Aufsetzen der zweiten Leiterplatte (2) auf den Kanal (5), so dass die zweite Kontaktfläche (10) mit zumindest einem der hervorstehenden Kontaktelemente(6) in Berührung kommt, und
Ausüben eines Drucks auf die zweite Leiterplatte (2) und Befestigen der zweiten Leiterplatte (2) relativ zur ersten Leiterplatte (1), so dass durch eine elastische Deformation der Kontaktelemente (6) und/oder des Kanals (5) eine elektrische Verbindung zwischen der ersten (3) und der zweiten Kontaktfläche (10) hergestellt wird.

## Beschreibung

Die Erfindung betrifft ein Verfahren zur Herstellung einer elektrischen Verbindung zwischen einem auf einer ersten Oberfläche einer ersten Leiterplatte vorgesehenen ersten Kontakt und einem auf einer zweiten Oberfläche einer zweiten Leiterplatte vorgesehenen zweiten Kontakt.

Aus der DE 10 2006 058 692 A1 sowie der DE 10 2007 006 212 A1 ist jeweils ein Verfahren zur Herstellung einer elektrischen Verbindung zwischen zwei Leiterplatten bekannt. Dabei weist eine erste Leiterplatte auf einer ersten Oberfläche eine erste Kontaktfläche auf. Auf die Oberfläche wird ein üblicherweise aus Kunststoff hergestelltes plattenartiges Zwischenstück gelegt, in welchem ein kanalartiger Durchgang vorgesehen ist. Das Zwischenstück liegt dabei so auf der ersten Leiterplatte, dass der Durchgang in Richtung der ersten Kontaktfläche weist. Anschließend wird in den Durchgang ein Federelement so eingesteckt, dass dessen erstes Ende mit der ersten Kontaktfläche in Berührung kommt. Dabei rangt ein zweites Ende des Federelements aus dem Durchgang über eine Oberseite des Zwischenstücks hervor. Anschließend wird eine zweite Leiterplatte, welche an einer zweiten Oberfläche eine zweite Kontaktfläche aufweist, so auf das Zwischenstück gelegt, dass die zweite Kontaktfläche mit dem zweiten Ende der Kontaktfeder in Berührung kommt. Die zweite Leiterplatte wird sodann gegen das Zwischenstück gedrückt und beispielsweise mittels Schrauben daran fixiert. In diesem Zustand verbindet die Kontaktfeder unter Vorspannung die auf der ersten Leiterplatte vorgesehene erste Kontaktfläche mit der auf der zweiten Leiterplatte vorgesehenen zweite Kontaktfläche. Eine damit hergestellte elektrische Verbindung ist robust und lässt sich einfach herstellen.

In der Praxis werden zur Erfüllung unterschiedlicher Anforderungen Zwischenstücke verwendet, welche eine unterschiedliche Höhe aufweisen. Infolgedessen müssen unterschiedliche, an die jeweilige Höhe des Zwischenstücks angepasste Kontaktfedern bereitgehalten werden. Es sind auch Baugruppen bekannt, bei denen mehrere Leiterplatten mit einer ersten Leiterplatte kontaktiert werden. In diesem Fall kann das Zwischenstück stufenförmig ausgebildet sein und Durchbrüche unterschiedlicher Höhe aufweisen. Auch hier müssen an die unterschiedliche Höhe der Durchbrüche angepasste unterschiedliche Kontaktfedern bereitgehalten werden. Bei der Montage kann es überdies dazu kommen, dass eine Kontaktfeder irrtümlich nicht in den dazu korrespondierenden Durchbruch gesteckt wird. Eine solcher fehlerhafte Montage einer Baugruppe verursacht zusätzlichen Aufwand. Ein weiterer wesentlicher Nachteil der Verwendung von Kontaktfedern besteht darin, dass diese an ihren Enden häufig scharfe Grate oder Kanten aufweisen. Bei der Verwendung einer mit derartigen Kontaktfedern kontaktierten Baugruppe in einer vibrierenden Umgebung, beispielsweise einem Fahrzeug oder dgl., kann es im Laufe der Zeit dazu kommen, dass die Kontaktflächen durch die daran anliegenden Kontaktfedern beschädigt und infolgedessen der elektrische Kontakt zwischen den Kontaktfedern und den Kontaktflächen unterbrochen wird.

Aufgabe der Erfindung ist es, die Nachteile nach dem Stand der Technik zu beseitigen. Es soll insbesondere ein möglichst einfaches, kostengünstiges und universelles Verfahren zur Herstellung einer elektrischen Verbindung zwischen zwei Leiterplatten angegeben werden.

Diese Aufgabe wird durch die Merkmale des Anspruchs 1 gelöst. Zweckmäßige Ausgestaltungen der Erfindung ergeben sich aus den Merkmalen der Ansprüche 2 bis 14.

Nach Maßgabe der Erfindung wird ein Verfahren zur Herstellung einer elektrischen Verbindung zwischen einer auf einer ersten Oberfläche einer ersten Leiterplatte vorgesehenen ersten Kontaktfläche und einer auf einer zweiten Oberfläche einer zweiten Leiterplatte vorgesehenen zweiten Kontaktfläche mit folgenden Schritten vorgeschlagen:
Vorsehen eines von der ersten Kontaktfläche sich erstreckenden Kanals,
Auffüllen des Kanals mit elektrisch leitfähigen, im Wesentlichen kugelförmig ausgebildeten Kontaktelementen, so dass die Kontaktelemente teilweise über einen freien Öffnungsrand des Kanals hervorstehen,
Aufsetzen der zweiten Leiterplatte auf den Kanal, so dass die zweite Kontaktfläche mit zumindest einem der hervorstehenden Kontaktelementen in Berührung kommt, und
Ausüben eines Drucks auf die zweite Leiterplatte und Befestigen der zweiten Leiterplatte relativ zur ersten Leiterplatte, so dass durch eine elastische Deformation der Kontaktelemente und/oder des Kanals eine elektrische Verbindung zwischen der ersten und der zweiten Kontaktfläche hergestellt wird.

Erfindungsgemäß werden die nach dem Stand der Technik bekannten einstückigen Kontaktfedern durch eine Füllung des Kanals mit einer Vielzahl von elektrisch leitfähigen, rieselfähigen Kontaktelementen ersetzt. Das vorgeschlagene Verfahren ist besonders universell. Es müssen insbesondere keine an die jeweilige Länge des Kanals spezifisch angepassten Kontaktfedern bereitgehalten werden. Es kann infolgedessen nicht mehr zu einer fehlerhaften Montage durch ein inkorrektes Einsetzen einer Kontaktfeder in einen dafür nicht vorgesehenen Durchbruch kommen.

Nach einer vorteilhaften Ausgestaltung der Erfindung erstreckt sich der Kanal im Wesentlichen senkrecht zur ersten und zweiten Oberfläche. Das erleichtert ein Auffüllen des Kanals mit den Kontaktelementen. Indem eine Richtung der Ausübung des Drucks der zweiten Leiterplatte gegen die erste Leiterplatte etwa parallel zu einer Achse des Kanals verläuft, kann sicher und zuverlässig ein elektrischer Kontakt zwischen den beiden Leiterplatten hergestellt werden.

Nach einer weiteren Ausgestaltung weisen die Kontaktelemente einen mittleren Durchmesser von 0,2 bis 5,0 mm auf. Zweckmäßigerweise werden Kontaktelemente mit einem weitgehend gleichen Durchmesser verwendet. Unter einem "weitgehend gleichen Durchmesser" wird eine Abweichung von einem mittleren Durchmesser von +/- 20%, vorzugsweise +/- 10%, verstanden. Die Verwendung von Kontaktelementen mit einem weitgehend gleichen Durchmesser erleichtert eine Automatisierung des Einfüllvorgangs der Kontaktelemente in den Kanal.

Die Kontaktelemente können in unterschiedlichen Ausgestaltungen vorliegen. Sie weisen zweckmäßigerweise eine Porosität von bis zu 80 Vol.% auf. Sie können insbesondere aus einem elektrisch leitfähigen Kompositwerkstoff, Elastomer oder aus Metall hergestellt sein. Die vorgeschlagenen Kontaktelemente weisen ein für die Durchführung der Erfindung geeignetes elastisches Verhalten auf. Deren Elastizitätsmodul ist vorteilhafterweise kleiner als 200 kN/mm². Er liegt zweckmäßigerweise im Bereich von 2 bis 130 kN/mm², besonders bevorzugt im Bereich von 5 bis 75 kN/mm².

Nach einer weiteren Ausgestaltung sind die Kontaktelemente als Hohlkugeln ausgebildet. Sie können auch aus gesintertem Metall hergestellt sein. Zur Herstellung derartiger als Formkörper ausgebildeter Kontaktelemente eignet sich beispielsweise Kupfer, Aluminium oder Legierungen mit den vorgenannten Metallen. Es ist auch möglich, auf einem aus einem elastischen Material hergestellten Körper eine elektrisch leitfähige Schicht vorzusehen. Die Kontaktelemente können insbesondere auch aus einem Elastomer hergestellt sein, welches mit elektrisch leitfähigen Fasern und/oder einem elektrisch leitfähigen Pulver hoch gefüllt ist. Die Fasern und/oder das Pulver können beispielsweise aus Grafit oder einem elektrisch leitfähigen Metall gebildet sein.

Nach einer weiteren Ausgestaltung weist der Kanal einen runden Querschnitt mit einem Durchmesser auf, der etwa 5 bis 30% größer ist als der mittlere Durchmesser der Kontaktelemente. Damit wird sichergestellt, dass die Kontaktelemente beim Einfüllen in den Kanal sich frei bewegen können und diesen vollständig ausfüllen.

Nach einer weiteren besonders vorteilhaften Ausgestaltung der Erfindung ist der Kanal aus einem elastischen Kunststoff hergestellt. In diesem Fall können zum Auffüllen des Kanals Kontaktelemente verwendet werden, welche elastisch lediglich mit einer geringen Formänderung deformiert werden können. Solche Kontaktelemente sind relativ preisgünstig verfügbar. Es kann sich dabei um aus Aluminium, Kupfer oder Legierungen mit den vorgenannten Metallen hergestellte Kugeln handeln. Bei der vorgeschlagenen Variante wird durch eine elastische Deformation des Kanals eine Kraft auf die Kontaktelemente ausgeübt, welche sie gegeneinander und gegen die auf den Leiterplatten vorgesehenen Kontaktflächen zwingt.

Die erfindungsgemäß vorgeschlagene kugelartige Form der Kontaktelemente zeichnet sich durch eine allseitige ballige Oberfläche aus. Die erfindungsgemäßen Kontaktelemente weisen im Gegensatz zu den nach dem Stand der Technik benutzten Kontaktfedern keine Grate oder scharfen Kanten auf. Bei einer Verwendung der erfindungsgemäßen Kontaktelemente zur Herstellung einer elektrischen Verbindung zwischen zwei Kontaktflächen kann sicher und zuverlässig auch in einer vibrierenden Umgebung eine Beschädigung der Kontaktflächen vermieden werden.

Nach einer vorteilhaften Ausgestaltung kann eine Wand des Kanals in einem mittleren Abschnitt mit zumindest einem axial sich erstreckenden Schlitz versehen sein. Zweckmäßigerweise sind mehrere Schlitze vorgesehen. Der Kanal kann insoweit beispielsweise ähnlich einem aus Kunststoff hergestellten "Dübel" ausgestaltet sein. Das Vorsehen des zumindest einen Schlitzes ermöglicht eine besonders große elastische Formänderung. Damit kann auf besonders sichere und zuverlässige Weise eine elektrische Verbindung zwischen zwei Leiterplatten hergestellt werden.

Nach einer weiteren Ausgestaltung der Erfindung ist der Kanal in einem Zwischenstück ausgebildet, welches zwischen der ersten und der zweiten Leiterplatte angeordnet wird. Zweckmäßigerweise wird das Zwischenstück auf die erste Leiterplatte aufgesetzt und die zweite Leiterplatte auf das Zwischenstück aufgesetzt. Ein solches Zwischenstück kann beispielsweise aus spritzgegossenem Kunststoff hergestellt sein. Darin können auch eine Vielzahl von Kanälen zur Herstellung einer Vielzahl von elektrischen Verbindungen zwischen einer Vielzahl auf der ersten Oberfläche vorgesehenen ersten Kontaktflächen und einer Vielzahl von auf der zweiten Oberfläche vorgesehenen zweiten Kontaktflächen vorgesehen sein.

Nach einer weiteren Ausgestaltung können die Kontaktelemente mit einem an einer Oberseite des Zwischenstücks angebrachten Haltemittel im Kanal gehalten werden. Das Haltemittel hält die Kontaktelemente so im Kanal zurück, dass sie kontaktierbar sind, jedoch nicht aus dem Kanal fallen können. In ähnlicher Weise kann auch an einer Unterseite des Zwischenstücks ein weiteres Haltemittel vorgesehen sein, mit dem die Kontaktelemente im Kanal gehalten werden. Das Haltemittel und/oder das weitere Haltemittel kann auch in einstückiger Ausbildung mit dem Zwischenstück hergestellt sein. In einer besonderen Ausgestaltung ist das Zwischenstück so geformt, dass im Kanal jeweils nur ein Kontaktelement aufgenommen ist, welches sowohl an der Ober- als auch an der Unterseite durch die Haltemittel im Kanal gehalten wird.

Nachfolgend werden Ausführungsbeispiele der Erfindung anhand der Zeichnungen näher erläutert. Es zeigen:
- Fig. 1: eine schematische Querschnittsansicht durch eine erste Leiterplatte mit einem aufgesetzten ersten Zwischenstück bei einem ersten Verfahrensschritt,
- Fig. 2: die erste Leiterplatte mit erstem Zwischenstück ge- mäß Fig. 1 nach einem zweiten Verfahrensschritt,
- Fig. 3: die erste Leiterplatte mit erstem Zwischenstück bei einem dritten Verfahrensschritt,
- Fig. 4: eine weitere erste Leiterplatte mit einem zweiten Zwischenstück beim ersten Verfahrensschritt,
- Fig. 5: eine weitere erste Leiterplatte mit einem dritten Zwischenstück und
- Fig. 6: eine Anordnung aus einer weiteren ersten sowie ei- ner zweiten Leiterplatte und einem vierten Zwi- schenstück.

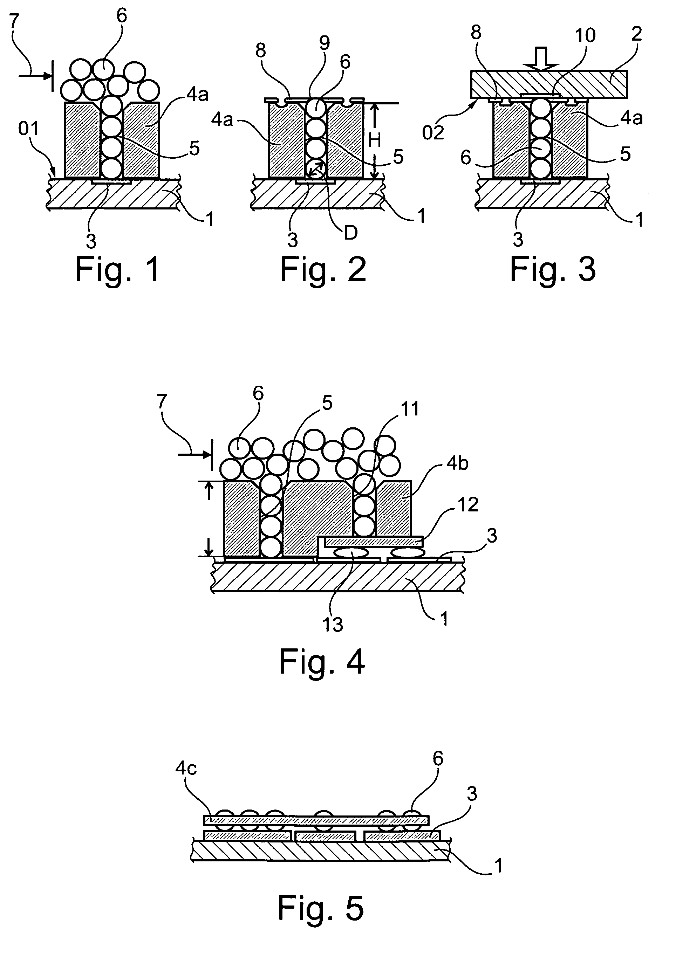

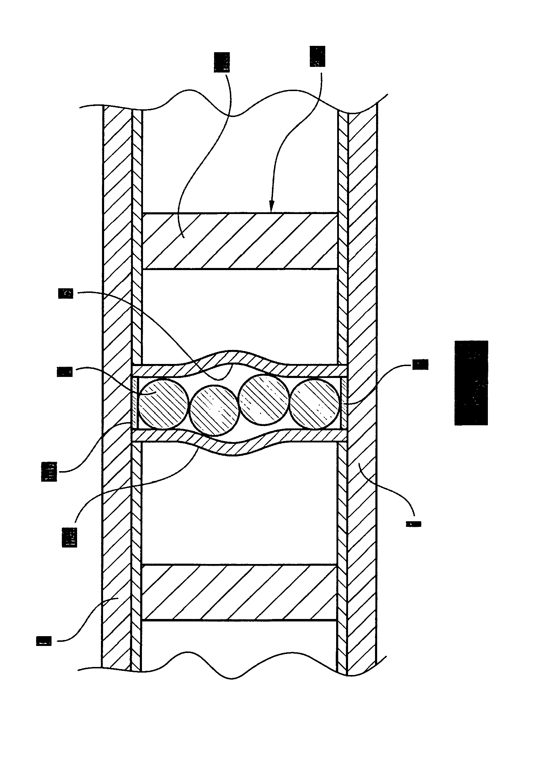

Die Fig. 1 bis 3 zeigen in schematischen Querschnittsansichten Verfahrensschritte zur Herstellung einer elektrischen Verbindung zwischen einer ersten Leiterplatte 1 und einer zweiten Leiterplatte 2. Die erste Leiterplatte 1 weist an ihrer ersten Oberfläche O1 eine erste Kontaktfläche 3 auf. Mit dem Bezugszeichen 4a ist ein auf der ersten Oberfläche O1 angeordnetes erstes Zwischenstück bezeichnet, welches beispielsweise aus spritzgegossenem Kunststoff hergestellt sein kann. Das erste Zwischenstück 4a weist einen Kanal bzw.

Durchbruch 5 auf, dessen Durchschnittsfläche vorzugsweise kreisförmig ist. Ein Durchmesser des Durchbruchs 5 ist vorzugsweise kleiner oder gleich einer Fläche der ersten Kontaktfläche 3. Das Zwischenstück 4a ist so auf der ersten Leiterplatte 1 angeordnet, dass der Durchbruch 5 sich über der ersten Kontaktfläche 3 befindet. Mit dem Bezugszeichen 6 sind kugelförmige Kontaktelemente bezeichnet, deren Durchmesser D kleiner ist als ein weiterer Durchmesser des Durchbruchs 5.

Der Durchmesser D der Kontaktelemente 6 ist vorzugsweise um 5 bis 30% kleiner als der weitere Durchmesser des Durchbruchs 5. Mit dem Bezugszeichen 7 ist schematisch eine Rakel bezeichnet, mit der an einer freien Oberseite des ersten Zwischenstücks 4a befindliche Kontaktelemente 6, welche sich nicht zumindest teilweise in den Durchbruch 5 erstrecken, entfernt werden können.

Fig. 2 zeigt die Situation nach dem Entfernen der roll- oder rieselfähigen Kontaktelemente 6 an der Oberseite des ersten Zwischenstücks 4a. Daraus ist insbesondere auch ersichtlich, dass eine Höhe H des Durchbruchs 5 kleiner ist als ein ganzzahliges Vielfaches des Durchmessers D der im Kanal aufnehmbaren Kontaktelemente 6. D. h. es steht immer ein Kontaktelement 6 zumindest teilweise über die Oberseite des ersten Zwischenstücks 4a hervor. Die erste Leiterplatte 1 kann zusammen mit dem ersten Zwischenstück 4a und den darin aufgenommenen Kontaktelement 6 ein eigenständiges Zwischenprodukt bilden, welches vom Kunden mit der zweiten Leiterplatte 2 versehen wird. In diesem Fall kann an der Oberseite des ersten Zwischenstücks 4a ein Haltemittel 8 angebracht sein, mit dem die Kontaktelemente 6 im Durchbruch 5 gehalten werden. Zu diesem Zweck kann das Haltemittel 8 einen weiteren Durchbruch 9 aufweisen, dessen weiterer Durchmesser kleiner als der Durchmesser D der Kontaktelemente 6 ist. Infolgedessen ragt ein oberstes Kontaktelement 6 teilweise über eine weitere Oberseite des Haltemittels 8 hervor.

Bei der in Fig. 3 gezeigten Anordnung ist eine zweite Kontaktfläche 10, welcher an einer zweiten Oberseite 02 der zweiten Leiterplatte 2 vorgesehen ist, in Kontakt mit den kugelförmigen Kontaktelementen 6. Durch die Kontaktelemente 6 wird ein elektrisch leitfähiger Pfad von der ersten 3 zur zweiten Kontaktfläche 10 hergestellt. Um auch im Falle von Erschütterungen, Vibrationen, Deformationen und dgl. stets eine sichere und zuverlässige elektrische Verbindung zwischen der ersten 3 und der zweiten Kontaktfläche 10 aufrechtzuerhalten, wird die zweite Leiterplatte 2 bei der Montage gegen den obersten, über die Oberseite des ersten Zwischenstücks 4a hervorstehenden Kontaktelemente 6 gedrückt. Infolgedessen werden die Kontaktelemente 6 elastisch deformiert. Die durch die elastische Deformation der Kontaktelemente 6 bereitgestellte Rückstellkraft zwingt die Kontaktelemente 6 gegeneinander sowie gegen die erste 3 und die zweite Kontaktfläche 10. Geeignete elastische Kontaktelemente 6 können beispielsweise aus einem mit einem elektrischen Füllstoff hoch gefüllten Elastomer, aus Kupfer oder Aluminium hergestellt sein. - Die zweite Leiterplatte 2 wird in diesem Zustand relativ zur ersten Leiterplatte 1 befestigt.

Bei der in Fig. 4 gezeigten zweiten Ausgestaltung weist ein zweites Zwischenstück 4b einen ersten Durchbruch 5 und einen zweiten Durchbruch 11 auf. Die Höhe H des ersten Durchbruchs 5 ist größer als eine weitere Höhe des zweiten Durchbruchs 11. Gleichwohl ist auch der zweite Durchbruch 11 in seiner weiteren Höhe so ausgestaltet, dass stets ein oberstes Kontaktelement 6 über die Oberseite des zweiten Zwischenstücks 4b hinausragt. Mit dem Bezugszeichen 12 ist eine Kontaktbrücke bezeichnet, welche über Quetschkontakte 13 zwei der ersten Kontaktflächen 3 miteinander verbindet. Anstelle der Kontaktbrücke 12 kann selbstverständlich auch eine weitere Leiterplatte vorgesehen sein, welche mit den ersten Kontaktflächen 3 der ersten Leiterplatte 1 kontaktiert ist. Zur Herstellung einer elektrischen Verbindung mit einer (hier nicht gezeigten) zweiten Leiterplatte ist es hier - ähnlich wie in den Fig. 1 bis 3 gezeigt ist - wiederum lediglich erforderlich, die Kontaktelemente 6 so auf die Oberseite des Zwischenstücks 4 aufzubringen, dass die darin vorgesehenen Durchbrüche 5, 11 aufgefüllt werden. Nachfolgend werden freie Kontaktelemente 6, d. h. nicht in die Durchbrüche 5, 11 ragende Kontaktelemente 6, mittels der Rakel 7 entfernt. Die Herstellung einer elektrisch leitfähigen Verbindung mit einer zweiten Leiterplatte 2 kann ähnlich wie in den Fig. 2 und 3 beschrieben ist, erfolgen.

Fig. 5 zeigt ein drittes Ausführungsbeispiel. Dabei ist lediglich eine einzige Lage kugelförmiger Kontaktelemente 6 auf den ersten Kontaktflächen 3 der ersten Leiterplatte 1 abgestützt. Die Kontaktelemente 6 sind hier in einem dritten Zwischenstück 4c gehalten. Das dritte Zwischenstück 4c dient einer exakten Positionierung der Kontaktelemente 6 bezüglich der ersten Kontaktflächen 3. Es kann zweckmäßigerweise auch dazu dienen, die ersten Kontaktelemente 6 unverlierbar zu halten. In diesem Fall bildet das dritte Zwischenstück 4c mit den darin aufgenommenen Kontaktelemente 6 eine Montageeinheit.

Fig. 6 zeigt eine vierte Ausgestaltung. Dabei ist der in einem vierten Zwischenstück 4d gebildete Kanal bzw. Durchbruch 5 von einer rohrartigen Wand 14 umgeben, welche aus einem elastischen Material, beispielsweise spritzgegossenem Kunststoff, hergestellt ist. Die Wand 14 kann (hier nicht gezeigte) Schlitze aufweisen, welche sich abschnittsweise in Axialrichtung erstrecken. Die hier wiederum kugelförmig ausgestalteten Kontaktelemente 6, welche allgemein einen Durchmesser von vorzugsweise 0,2 bis 5,0 mm aufweisen können, sind hier aus einem Material hergestellt, welches lediglich eine geringe elastische Formänderung aufweist. Es kann sich dabei beispielsweise um Stahl handeln. Durch den bei der Montage auf die Kontaktelemente 6 mittels der zweiten Leiterplatte 2 ausgeübten Druck werden die Kontaktelemente 6 gegen die Wand 14 gezwungen, welche sich elastisch verformt. Die elastische Rückstellkraft der Wand 14 zwingt die Kontaktelemente 6 gegeneinander sowie gegen die Kontaktflächen 3, 10. Es wird wiederum eine sichere und zuverlässige elektrische Verbindung zwischen der ersten Kontaktfläche 3 über die Kontaktelemente 6 mit der zweiten Kontaktfläche 10 hergestellt. Mit dem Bezugszeichen 15 sind Stützelemente bezeichnet, mit denen das vierte Zwischenstück 4d so stabilisiert wird, dass bei der Ausübung eines Drucks auf die Kontaktelemente 6 es tatsächlich zu einer elastischen Deformation der Wand 14 kommt.

### Bezugszeichenliste

- 1: erste Leiterplatte
- 2: zweite Leiterplatte
- 3: erste Kontaktfläche
- 4a: erstes Zwischenstück
- 4b: zweites Zwischenstück
- 4c: drittes Zwischenstück
- 4d: viertes Zwischenstück
- 5: Durchbruch
- 6: Kontaktelement
- 7: Rakel
- 8: Haltemittel
- 9: weiterer Durchbruch
- 10: zweite Kontaktfläche
- 11: zweiter Durchbruch
- 12: Kontaktbrücke
- 13: Quetschkontakt
- 14: Wand
- 15: Stützelement

- D: Durchmesser
- H: Höhe
- O1: erste Oberfläche
- 02: zweite Oberfläche

## Patentansprüche

1. Verfahren zur Herstellung einer elektrischen Verbindung zwischen einer auf einer ersten Oberfläche (O1) einer ersten Leiterplatte (1) vorgesehenen ersten Kontaktfläche (3) und einer auf einer zweiten Oberfläche (02) einer zweiten Leiterplatte (2) vorgesehenen zweiten Kontaktfläche (10), mit folgenden Schritten:
Vorsehen eines von der ersten Kontaktfläche (3) sich erstreckenden Kanals (5),
Auffüllen des Kanals (5) mit elektrisch leitfähigen, im Wesentlichen kugelförmig ausgebildeten Kontaktelementen (6), so dass die Kontaktelemente (6) teilweise über einen freien Öffnungsrand des Kanals (5) hervorstehen,
Aufsetzen der zweiten Leiterplatte (2) auf den Kanal (5), so dass die zweite Kontaktfläche (10) mit zumindest einem der hervorstehenden Kontaktelemente(6) in Berührung kommt, und
Ausüben eines Drucks auf die zweite Leiterplatte (2) und Befestigen der zweiten Leiterplatte (2) relativ zur ersten Leiterplatte (1), so dass durch eine elastische Deformation der Kontaktelemente (6) und/oder des Kanals (5) eine elektrische Verbindung zwischen der ersten (3) und der zweiten Kontaktfläche (10) hergestellt wird.

2. Verfahren nach Anspruch 1, wobei sich der Kanal (5) im Wesentlichen senkrecht zur ersten (O1) und zweiten Oberfläche (02) erstreckt.

3. Verfahren nach einem der vorhergehenden Ansprüche, wobei die Kontaktelemente (6) einen mittleren Durchmesser (D) von 0,2 bis 5,0 mm aufweisen.

4. Verfahren nach einem der vorhergehenden Ansprüche, wobei die Kontaktelemente (6) eine Porosität von bis zu 80 Vol.% aufweisen.

5. Verfahren nach einem der vorhergehenden Ansprüche, wobei die Kontaktelemente (6) aus einem elektrisch leitfähigen Kompositwerkstoff, Elastomer oder aus Metall hergestellt sind.

6. Verfahren nach einem der vorhergehenden Ansprüche, wobei die Kontaktelemente (6) als Hohlkugeln ausgebildet sind.

7. Verfahren nach einem der vorhergehenden Ansprüche, wobei die Kontaktelemente (6) aus gesintertem Metall hergestellt sind.

8. Verfahren nach einem der vorhergehenden Ansprüche, wobei der Kanal (5) einen runden Querschnitt mit einem Durchmesser aufweist, der etwa 5 bis 30% größer ist als der mittlere Durchmesser (D) der Kontaktelemente (6).

9. Verfahren nach einem der vorhergehenden Ansprüche, wobei eine von der ersten (3) bis zur zweiten Kontaktfläche (10) sich erstreckende Höhe (H) des Kanals (5) kleiner ist als ein ganzzahliges Vielfaches des mittleren Durchmessers (D) der im Kanal (5) aufnehmbaren Kontaktelemente (6).

10. Verfahren nach einem der vorhergehenden Ansprüche, wobei der Kanal (5) aus einem elastischen Kunststoff hergestellt ist.

11. Verfahren nach einem der vorhergehenden Ansprüche, wobei ein Wand (14) des Kanals (5) in einem mittleren Abschnitt mit zumindest einem axial sich erstreckenden Schlitz versehen ist.

12. Verfahren nach einem der vorhergehenden Ansprüche, wobei der Kanal (5) in einem Zwischenstück (4a, 4b, 4c, 4d) ausgebildet ist, welches zwischen der ersten (1) und der zweiten Leiterplatte (2) angeordnet wird.

13. Verfahren nach einem der vorhergehenden Ansprüche, wobei die Kontaktelemente (6) mit einem an einer Oberseite des Zwischenstücks (4a, 4b, 4c, 4d) angebrachten Haltemittel (8) im Kanal (5) gehalten werden.

14. Verfahren nach einem der vorhergehenden Ansprüche, wobei das die Kontaktelemente (6) mit einem an einer Unterseite des Zwischenstücks (4a, 4b, 4c, 4d) angebrachten weiteren Haltemittel im Kanal (5) gehalten werden.
